Europäisches Patentamt

European Patent Office

Office européen des brevets

(19)

(11) Publication number: **0 241 236**
**A2**

(12)

# EUROPEAN PATENT APPLICATION

(21) Application number: **87302909.4**

(22) Date of filing: **02.04.87**

(51) Int. Cl.4: **H 03 H 9/05**

(30) Priority: **11.04.86 US 850835**

(43) Date of publication of application:
**14.10.87 Bulletin 87/42**

(84) Designated Contracting States:
**DE ES FR GB IT NL**

(71) Applicant: **AMERICAN TELEPHONE AND TELEGRAPH COMPANY**
**550 Madison Avenue**
**New York, NY 10022 (US)**

(72) Inventor: **Andrews, George Edward**
**419 West Somerset Street**
**Fleetwood Pennsylvania 19522 (US)**

**Davis, Paul Cooper**
**3601 River Road**
**Reading Pennsylvania 19605 (US)**

**Farley, Dennis Charles**
**R.D. No. 4, Box 248**
**Coopersburg Pennsylvania 13036 (US)**

**Kravitz, Stanley H.**
**R.D. No. 2, Box 446C**
**Coopersburg Pennsylvania 18036 (US)**

**Meeker, Thrygve Richard**
**2956 Lindberg Avenue**
**Allentown Pennsylvania 18103 (US)**

**Petersen, Owe George**
**3503 Romig Avenue**
**Reading Pennsylvania 19606 (US)**

**Schelling, Arthur Warren**
**721 North Third Street**
**Emmaus Pennsylvania 18049 (US)**

(74) Representative: **Johnston, Kenneth Graham et al**
**Western Electric Company Limited 5 Mornington Road**
**Woodford Green Essex, IG8 OTU (GB)**

(54) Cavity package for saw devices and associated electronics.

(57) A multilayer ceramic package (10) for surface acoustic wave (SAW) devices is disclosed which includes two separate cavities (27,32) disposed in a vertical arrangement. The SAW device is positioned in a first one of the cavities and the electronics associated with the operation of the SAW device are located in the second, remaining cavity. Extremely short lead lengths between the SAW device and the electronics, necessary for high frequency applications, are provided by using a number of metallized vias (48,50) formed through the multilayer structure. By positioning the SAW device and the electronics in two separate cavities, the manufacturing process associated with providing a single chip, fully integrated SAW arrangement is greatly simplified. The utilization of multilayer ceramic package offers the additional advantage of providing a hermetic structure.

FIG. 2

EP 0 241 236 A2

**Description**

## CAVITY PACKAGE FOR SAW DEVICES AND ASSOCIATED ELECTRONICS

Background of the Invention

1. Field of the Invention

The present invention relates to a package for SAW (surface acoustic wave) devices and their associated electronics.

2. Description of the Prior Art

Device packaging techniques have become more critical recently, as devices are becoming increasingly smaller while also being subjected to a more varied environment - for example, undersea, terrestrial, and outer space. SAW devices in particular, due to their high frequency applications, are greatly affected by packaging differences - both in performance and cost. Hermeticity, package size, and temperature stability are just a few of the parameters SAW package designers must address.

An article entitled "Vertical Inline SAW Package (VISP)", by C. A. Erikson et al appearing in the Proceeding of the 1983 Ultrasonics Symposium addresses these and other problems. The article describes the "ideal" SAW package as the smallest enclosure capable of protecting the SAW device with a lead frame attachment which is electrically reliable and easy to handle. A vertical package structure is then proposed as one such design structure, where the SAW device mounts vertically onto the associated printed circuit boards, utilizing a ceramic substrate with a metal enclosure.

An alternative packaging technique for SAW devices, particularly for those deployed in undersea applications, is discussed in the article "An Undersea Fiber-Optic Regenerator Using an Integral-Substrate Package and Flip-Chip SAW Mounting" by P. A Dawson et al appearing in the Journal of Lightwave Technology, Vol. LT-2, No. 6, December 1984 at pp. 926-932. Unlike the vertical package discussed above, the Dawson et al arrangement mounts the SAW device in a horizontal manner onto the substrate. In order to protect the top surface of the SAW from damage, since the electrodes forming the transducers are formed on the top surface the SAW is mounted upside down using metal tapes attached to gold bonding areas to provide both physical and mechanical attachment of the SAW to the substrate.

A need remains in the prior art for a SAW package which is capable of also including the associated electronics and which can be utilized in any environment, while also allowing relatively simple manufacturing.

Summary of the Invention

A multi-layer ceramic "piggy-back" style double cavity package is provided where the integrated circuit is formed in a first cavity disposed beneath a second cavity containing the SAW device.

Brief Description of the Drawings

FIG. 1 is a partial cut away perspective view of an exemplary SAW double cavity package formed in accordance with the present invention;

FIG. 2 is a exploded view of the arrangement of FIG. 1, illustrating each of the various layers forming the exemplary SAW double cavity package; and

FIG. 3 is an alternative cut away view in perspective illustrating the various ceramic layers delineated in FIG. 2.

Detailed Description

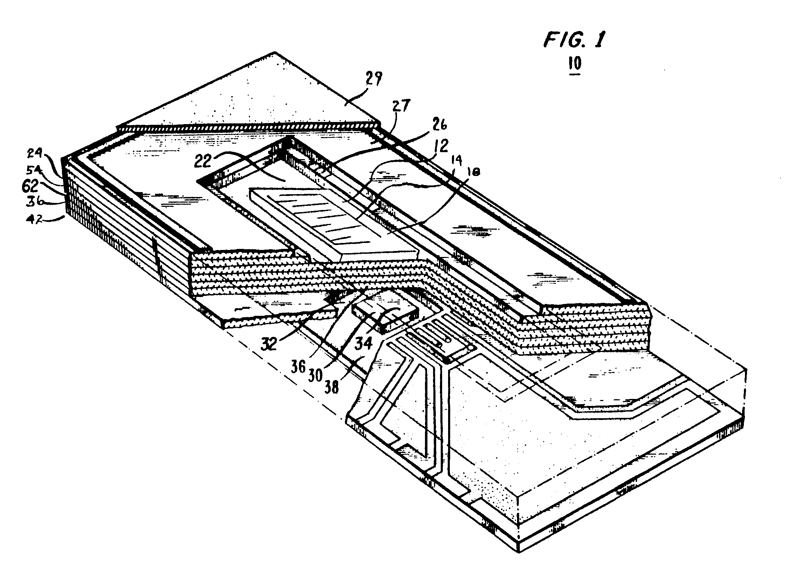

For the purposes of the present discussion, the double cavity package of the invention is illustrated as holding the SAW device in a top cavity and the electronics in a bottom cavity. However, it is to be understood that the inverse type of package, with the integrated circuit in the top cavity and the SAW in the bottom cavity, is possible. Referring now to FIG. 1, a double-cavity package 10 is shown in which a SAW filter 12, including an input transducer 14 and an output transducer (not shown) formed on a quartz substrate 18 is disposed in a first, or top, cavity 22. Quartz substrate 18, as shown, rests on a ground plane layer 24. Cavity 22 is formed by annular openings in ceramic layers 26 and 27, as illustrated in FIG. 1. A top sealing layer 29 is also partially illustrated in FIG. 1, where sealing layer 29 is usually formed of a metallic alloy, for example, Kovar, which forms a hermetic seal when bonded to a metal sealing ring deposited on top of the ceramic material forming the internal layers of the package.

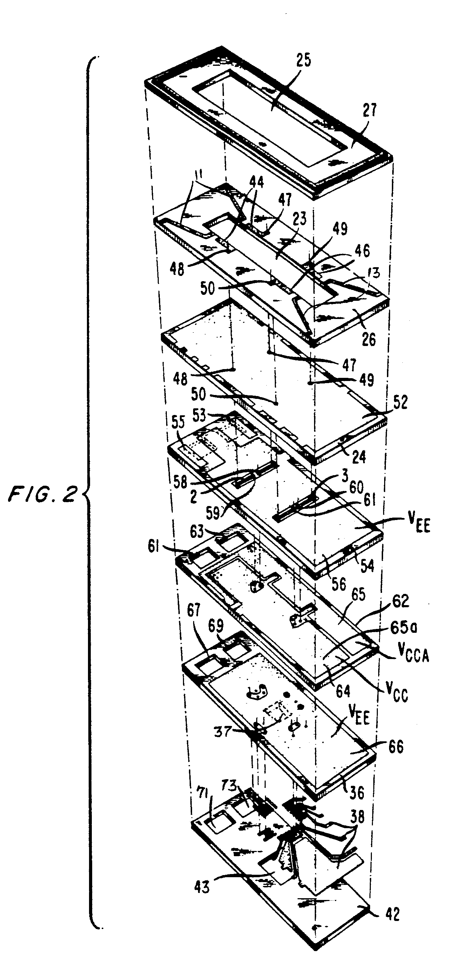

The associated integrated electronics, represented by substrate 30 in FIG. 1, are placed in a second, or lower, cavity 32. Similar to the placement of quartz substrate 18, a surface 34 of integrated circuit substrate 30 engages an associated ground plane 66 (FIG. 2) disposed on a layer 36. Lower cavity 32 is also created by annular openings, the first such opening being formed in ceramic layer 36 and another opening in a subsequent layer 42. A bottom sealing layer 38 (FIG. 1), which may also comprise Kovar (a known composition of for example, iron, nickel, and cobalt), is used to cover lower cavity 32 and provide a hermetic seal for package 10. As discussed hereinafter in association with FIG. 2, the connections between SAW filter 12 and integrated circuit 30 are performed by conductive vias which run in a vertical direction through the appropriate layers.

In one embodiment, the ceramic layers of the package 10 may comprise alumina ($Al_2O_3$) , which is known to provide a good hermetic seal when sintered at an elevated temperature. However, various other ceramic materials may also be utilized to form the described multi-layer package. As discussed hereinafter, various ones of the ceramic layers are provided with metallized patterns to produce the desired electrical connection between integrated circuit 30 and SAW filter 12. Typically these metallization areas are produced by deposition using masking or screening techniques to apply successive layers of suitable metals. The metallization patterns illustrated in FIG. 2 are exemplary only.

Cavities 22 and 32, as mentioned above, are each defined by a combination of ceramic layers having annular cavities and a solid ceramic mounting layer. Thus, upper cavity 22 is formed by ceramic layers 26 and 27 (FIG. 2) having annular openings 23 and 25, respectively, the layers 26 and 27 being mounted on ceramic layer 24 which has mounting means including a metallized ground plane 52 as discussed hereinafter. In a similar fashion, lower cavity 32 is formed by a ceramic layer 42 having an annular opening 43, where layer 42 is positioned under mounting layer 36 which includes an annular opening 37. As stated above, integrated circuit 30 engage a metallized layer 66 formed on top of ceramic layer 36.

Ceramic layer 26 includes metallized electrodes 44 and 46 which are connected respectively to input transducer 14 and the output transducer of SAW filter 12. Also illustrated are a number of conductive vias 47-50 which serve as the actual conduction paths between the transducers and integrated circuit 30 in the lower cavity. An additional plurality of electrodes 11 and 13 are included on ceramic layer 26 and wire bonded to electrodes 44 and 46, respectively. Electrodes 11 and 13 may then be connected to an external signal generator (not shown) to test SAW filter 12 prior to final encapsulation. As mentioned above, ceramic layer 24 forms the mounting layer for upper cavity 22, and SAW filter 12 engages the top surface of ceramic layer 24 when the final package is assembled. Ceramic layer 24 forms the package ground layer for this particular configuration, where a large portion of the top surface of layer 24 is covered with a metallized layer 52 which forms the actual ground plane for the package. As shown, the metallized vias 47-50 continue through ground plane 52. The next package layer, formed by ceramic layer 54, forms a power supply layer, denoted $V_{EE}$, for integrated circuit 30. A metallized layer 56 on the top surface of layer 54 is used to define this $V_{EE}$ power supply. In order to accommodate the actual positions of the SAW filter inputs and outputs, the electrical connections continue from vias 47-50 to vias 58-61, respectively, by the use of electrode strips 1-4, as shown with reference to layer 54. Vias 58-61 then continue the connection of the SAW filter inputs and outputs to the electronics contained in the lower layers of package 10. A pair of metallic strips 53 and 55 are also formed on layer 54, as shown in phantom in FIG. 2. Metallic strips 53 and 55, as discussed in further detail below, are used to create a capacitive decoupling arrangement for package 10. Ceramic layer 54 also includes a pair of annular openings 39 and 41 (shown in phantom) disposed directly beneath metallic strips 53 and 55. These openings, as discussed below, are utilized to create openings in package 10 for the later placement of a pair of discrete capacitors.

Power supplies to integrated circuit 30, denoted $V_{CC}$ and $V_{CCA}$, are provided by the next ceramic layer 62, which includes metallized layers 64 and 65 connected to external power supplies for $V_{CC}$ and $V_{CCA}$ (not shown). A number of vias, not specifically illustrated in FIG. 2, are utilized to connect the power supply from metallized layers 64a and 65 to integrated circuit 30. Additional vias in ceramic layer 62 are utilized to connect metal layer 64 to metallic strip 55 and, similarly, to connect metal layer 65 to metallic strip 53. Therefore, a pair of capacitors may be placed in openings 39 and 41, one capacitor connected between $V_{EE}$ and $V_{CC}$ (layers 56 and 64) and another capacitor between $V_{EE}$ and $V_{CCA}$ (layers 56 and 65). This capacitive arrangement is used to provide decoupling between the various power supplies. A pair of annular openings 61 and 63 to facilitate placement of the decoupling capacitors are also included in ceramic layer 62 and are disposed directly beneath annular openings 39 and 41, respectively. An additional integrated circuit power supply, denoted $V_{EE}$, is formed on layer 36 which is disposed underneath power layer 62. As shown, ceramic layer 36 includes a metallized layer 66 which is connected to an external $V_{EE}$ power supply (not shown), where metallized layer 66 serves as the mounting surface for integrated circuits 30. An additional pair of openings 67 and 69 are formed in layer 36 and are disposed directly underneath openings 61 and 63 in ceramic layer 62. Annular opening 37 is illustrated in phantom through layer 66, where integrated circuit 30 (not shown) is disposed in opening 37 and mounted on layer 66, in the same manner as filter 12 is disposed in opening 23 and mounted on layer 52.

The metallization pattern 38 required to connect integrated circuit 30 to external signal sources are formed on the bottom of the ceramic layer 36, and is illustrated as separated from layer 36 for the sake of clarity. Following layer 36 is a ceramic layer 42, with annular opening 43, as discussed above, to facilitate the placement of integrated circuits 30 in bottom cavity 32. An additional pair of annular openings 71 and 73 are provided to allow for the placement of decoupling capacitors, openings 71 and 73 being disposed directly underneath openings 67, 69 in ceramic layer 36. As mentioned above, a bottom sealing layer (not shown), preferentially formed of Kovar, is used to cover over bottom cavity 32 and provide a hermetic seal for the completed package.

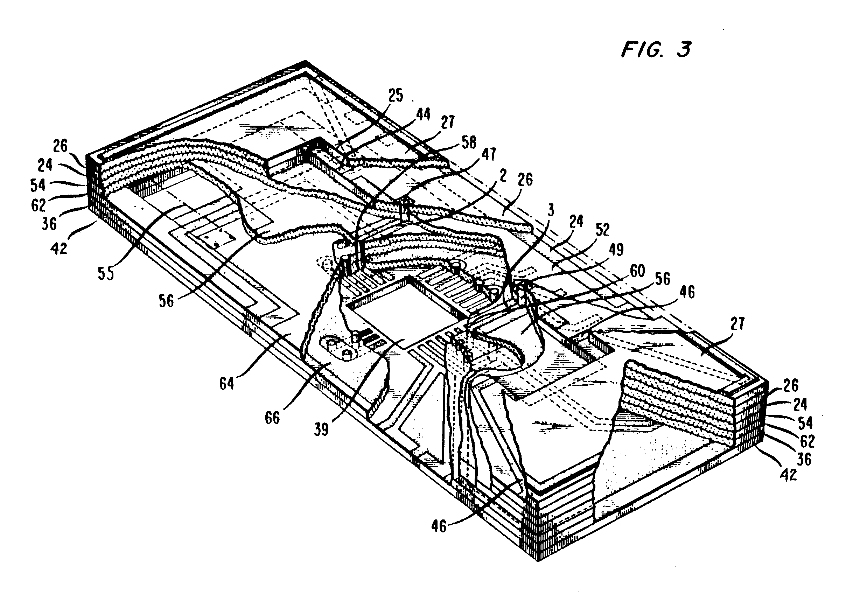

After the combination of the various ceramic layers are formed, they are pressed together to form the final double cavity package structure. FIG. 3 illustrates an exemplary package 10, in a cut away view, after the various ceramic layers are joined together. An advantage of this packaging arrangement is the ability to fabricate the SAW filter and the integrated circuit as completely separate entities, since both components are simply dropped into their respective cavities subsequent to the package manufacturing process. Thus, the SAW filter is not subjected to the various environmental stresses (temperature ramping, high temperatures, different ambient gasses, etc.) associated with integrated circuit assembly.

## Claims

1. A multilayer ceramic package for surface acoustic wave devices and associated integrated electronics, characterized in that the package comprises

a first plurality of ceramic layers (26,27) each having an annular opening;

a first mounting layer (24) including a first mounting surface (52), the combination of said first mounting layer with said first plurality of ceramic layers forming a first package cavity (22), for containing a surface acoustic wave device to be disposed on said mounting surface;

a second plurality of ceramic layers (42,36) each having an annular opening; and

a second mounting surface (66), the combination of said mounting surface with said second plurality of ceramic layers forming a second package cavity (32), aligned vertically with and separated from said first cavity, said second cavity being adopted to contain an integrated circuit device to be disposed on said mounting surface, interconnections between said devices when assembled in said package being provided by a plurality of vias (47,49) including in the ceramic layers separating said first and second cavities.

2. A package as defined in claim 1, characterised in that the ceramic used to form each layer comprises a material which forms a hermetic seal when the final package is sintered at an elevated temperature.

3. A package as defined in claim 2, characterised in that the ceramic is alumina.

4. A package as defined in claim 1 or 2 characterised in that the package further comprises

a first sealing layer (29) disposed to completely cover the first cavity; and

a second sealing layer (38) disposed to completely cover the second cavity.

0241236

FIG. 1
10

FIG. 2

FIG. 3